(19) **Europäisches Patentamt / European Patent Office / Office européen des brevets**

(11) **EP 1 983 657 A1**

(12) **EUROPEAN PATENT APPLICATION**
published in accordance with Art. 158(3) EPC

(43) Date of publication:
**22.10.2008 Bulletin 2008/43**

(21) Application number: **06833391.3**

(22) Date of filing: **27.11.2006**

(51) Int Cl.:
**H04B 7/005** (2006.01)    **H03H 21/00** (2006.01)
**H04B 1/10** (2006.01)    **H04B 3/06** (2006.01)
**H04L 27/01** (2006.01)

(86) International application number:
**PCT/JP2006/323587**

(87) International publication number:
**WO 2007/091363 (16.08.2007 Gazette 2007/33)**

(84) Designated Contracting States:
**DE FR GB**

(30) Priority: **07.02.2006 JP 2006029981**

(71) Applicant: **Pioneer Corporation**
**Tokyo 153-8654 (JP)**

(72) Inventors:
• **KURIYAMA, Hiromitsu**
**Kawagoe-shi, Saitama 3508555 (JP)**

• **YAMAMOTO, Yuji**
**Kawagoe-shi, Saitama 3508555 (JP)**

(74) Representative: **Popp, Eugen**
**Meissner, Bolte & Partner GbR**
**Postfach 86 06 24**
**D-81633 München (DE)**

(54) **ADAPTIVE DIGITAL FILTER AND RECEIVER**

(57)     An adaptive digital filter is provided which eliminates from a digitized modulated signal the effects of transmission path characteristics such as multipath characteristics, thereby eliminating the effects of direct current components contained in the modulated signal to provide adaptive control.

The adaptive digital filter includes: a transversal filter 3B for performing predetermined digital filtering on a digitized modulated signal X(t); a discrimination decision section 3c for computing an error E(t) between the envelope EY(t) of an output Y(t) from the transversal filter 3B and a predetermined reference value BS; and an estimation control section 3D for providing adaptive control by adjusting tap coefficients h(0) to h(m) of the transversal filter 3B for the error E (t) to converge to 0. The estimation control section 3D allows the output Y(t) of the transversal filter 3b to be produced as a modulated signal from which the effects of transmission path characteristics such as multipath characteristics have been eliminated. The estimation control section 3D sets the tap coefficients h(0) to h(m) to a predetermined initial coefficient value, thereby setting the frequency characteristics of the transversal filter 3B to such frequency characteristics that prevent the passage of direct current components contained in the digitized modulated signal. The estimation control section 3D then provides the adaptive control, thereby eliminating the effects of direct current components contained in the modulated signal X(t).

FIG.1(a)

FIG.1(b)

**Description**

**TECHNICAL FIELD**

The present invention relates to receivers for receiving modulated signals such as frequency-modulated or phase-modulated signals, and in particular, to a receiver with an adaptive digital filter for eliminating the effects of transmission path characteristics such as multipath characteristics.

**BACKGROUND ART**

To eliminate the effects of transmission path characteristics such as multipath characteristics, some conventional receivers for receiving, for example, radio FM broadcast, are known to include an adaptive digital filter which serves as an automatic equalizer (see Patent Document 1).

The adaptive digital filter is formed to include a transversal filter which is represented by a transfer function H (z) expressed in the z-transform notation shown in Equation (1a) below. The transversal filter is designed to receive an intermediate frequency signal (IF signal) produced, for example, at a frontend section, via an A/D converter and an automatic gain control (AGC) circuit. The IF signal is thus analog-to-digital converted at the A/D converter and subjected to automatic gain control at the AGC circuit to yield a digital IF signal $X(t)$. Then, the transversal filter allows the IF signal $X(t)$ to be multiplied by a plurality of tap coefficients $h(0)$ to $h(m)$ while being delayed when transferred through a plurality of delay elements. The multiplication results are then added up to yield a digital IF signal $Y(t)$, which contains impulse response trains expressed by Equation (1b) below. In the equation, the coefficient T is the delay time of each delay element or a component of the transversal filter, and determined based on the sampling frequency of the A/D converter.

[Equation 1]

$$H(z) = \sum_{i=0}^{m} h(i) z^{-1} \qquad \cdots (1a)$$

$$Y(t) = \sum_{i=0}^{m} h(i) X(t - iT) \qquad \cdots (1b)$$

Furthermore, the conventional adaptive digital filter employs as an evaluation function the error between a predetermined constant value (reference value) and the digital IF signal $Y(t)$ because the envelope of an ideal FM wave (a modulated signal obtained by Frequency Modulation) is at a constant level. The adaptive digital filter adaptively adjusts the tap coefficients $h(0)$ to $h(m)$ so that the error converges to 0, thereby producing the digital IF signal $Y(t)$ with the effects of transmission path characteristics such as multipath characteristics eliminated. The digital IF signal $Y(t)$ is then supplied to an FM detector for detection and demodulation, thereby producing a demodulated signal.

Patent Document 1: Japanese Published Unexamined Patent Application No. Hei 10-209890

**DISCLOSURE OF THE INVENTION**

**PROBLEMS TO BE SOLVED BY THE INVENTION**

As described above, to supply the IF signal or a modulated signal produced at the frontend section or the like to the adaptive digital filter, the aforementioned conventional receiver employs the A/D converter and the AGC circuit to produce the digital IF signal $X(t)$.

However, the analog-to-digital conversion of the IF signal at the A/D converter causes the digital IF signal $X(t)$ to contain not only the signal component of the IF signal itself but also a direct current component depending on the performance of the A/D converter. Moreover, the direct current component is amplified at the AGC circuit to a high-level direct current component to be contained in the digital IF signal $X(t)$.

Furthermore, the adaptive digital filter employs as the evaluation function the error between the aforementioned constant reference value and the digital IF signal $Y(t)$. Thus, the tap coefficients $h(0)$ to $h(m)$ may be changed so as to converge to the aforementioned direct current component contained in the digital IF signal $X(t)$. In some cases, it was not possible to produce the digital IF signal Y(t) with the effects of transmission path characteristics such as multipath characteristics sufficiently eliminated.

Furthermore, since the aforementioned direct current component may depend on a direct current offset of the A/D converter, the direct current offset may be taken into consideration to narrow the maximum gain of the AGC circuit. For example, upon reception of a weak electric field, this would cause the level of the intrinsic signal component of the IF signal supplied to the adaptive digital filter to become relatively low, with insufficient use being made of the function of the adaptive digital filter. This would result in the effects of transmission path characteristics such as multipath characteristics being eliminated with difficulty.

The present invention was developed in view of these conventional problems. It is therefore an object of the present invention to provide an adaptive digital filter and a receiver which can perform effective adaptive processing to eliminate the effects of transmission path characteristics such as multipath characteristics even when a modulated signal contains a direct current component.

**MEANS FOR SOLVING THE PROBLEMS**

The invention according to claim 1 provides an adaptive digital filter for eliminating effects of transmission path characteristics such as multipath characteristics from a digitized modulated signal. The adaptive digital filter includes: a transversal filter for performing predetermined digital filtering on the digitized modulated signal; discrimination decision means for computing an error between an envelope of an output from the transversal filter and a predetermined reference value; and estimation control means for providing adaptive control by adjusting a tap coefficient of the transversal filter for the error to converge, so that the output from the transversal filter is produced as a modulated signal with the effects of transmission path characteristics such as multipath characteristics eliminated. The estimation control means provides the adaptive control after the tap coefficient is set to a predetermined initial coefficient value, thereby setting frequency characteristics of the transversal filter to such frequency characteristics that prevent passage of a direct current component contained in the digitized modulated signal.

The present invention according to claim 4 provides a receiver which includes: the adaptive digital filter according to any one of claims 1 to 3; an A/D converter for analog-to-digital conversion of an analog modulated signal; automatic gain control means for providing automatic gain control to an output from the A/D converter to produce the digitized modulated signal for supply to the adaptive digital filter; and detector means for detecting and demodulating an output from the transversal filter.

The present invention according to claim 5 provides a method for performing adaptive digital filtering to eliminate effects of transmission path characteristics such as multipath characteristics from a digitized modulated signal. The method includes: a digital filtering step of performing predetermined digital filtering on the digitized modulated signal; a discrimination decision step of computing an error between an envelope of the digitally filtered signal from the digital filtering step and a predetermined reference value; and an estimation control step of providing adaptive control by adjusting a tap coefficient in the digital filtering step for the error to converge, so that the digitally filtered signal is produced as a modulated signal with the effects of transmission path characteristics such as multipath characteristics eliminated. In the estimation control step, the adaptive control is provided after the tap coefficient is set to a predetermined initial coefficient value, thereby setting frequency characteristics for the digital filtering in the digital filtering step to such frequency characteristics that prevent passage of a direct current component contained in the digitized modulated signal.

The present invention according to claim 6 provides a computer program for allowing a computer to perform adaptive digital filtering to eliminate effects of transmission path characteristics such as multipath characteristics from a digitized modulated signal. The computer program includes: a digital filtering step of performing predetermined digital filtering on the digitized modulated signal; a discrimination decision step of computing an error between an envelope of the digitally filtered signal from the digital filtering step and a predetermined reference value; and an estimation control step of providing adaptive control by adjusting a tap coefficient of the digital filtering step for the error to converge, so that the digitally filtered signal is produced as a modulated signal with the effects of transmission path characteristics such as multipath characteristics eliminated. In the estimation control step, the adaptive control is provided after the tap coefficient is set to a predetermined initial coefficient value, thereby setting frequency characteristics for the digital filtering in the digital filtering step to such frequency characteristics that prevent passage of a direct current component contained in the digitized modulated signal.

**BRIEF DESCRIPTION OF THE DRAWINGS**

Fig. 1 is a block diagram illustrating the configuration of a receiver and an adaptive digital filter according to an embodiment.

Fig. 2 is a block diagram illustrating the configuration of a receiver and an adaptive digital filter according to an example.

Fig. 3 is a characteristic diagram illustrating the frequency characteristics of the adaptive digital filter shown in Fig. 2 (b).

**BEST MODE FOR CARRYING OUT THE INVENTION**

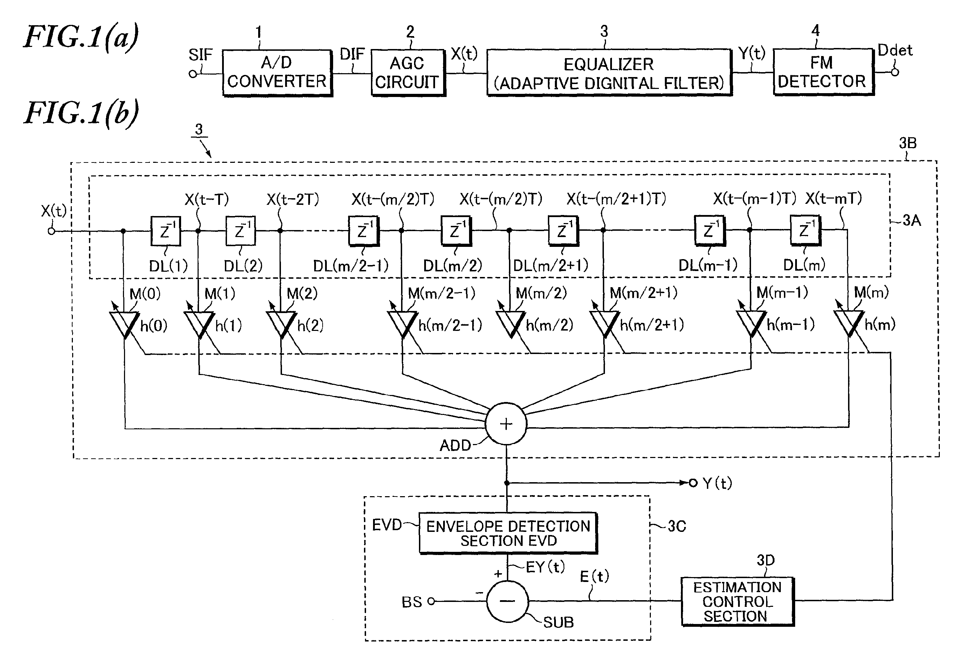

A description will now be made to a preferred embodiment of the present invention with reference to Fig. 1. Fig. 1 (a) is a block diagram illustrating the configuration of a receiver according to the present embodiment, and Fig. 1 (b) is a block diagram illustrating the configuration of an adaptive digital filter.

In Fig. 1(a), the receiver of the present embodiment is configured to include an A/D converter 1, an automatic gain control circuit (AGC circuit) 2, an adaptive digital filter 3 serving as an automatic equalizer, and an FM detector 4. In this arrangement, a front end section and an IF section (not shown) synchronously receive incoming radio waves such as FM broadcasts to produce an IF signal (modulated signal) SIF. The A/D converter 1 converts the IF signal SIF from analog to digital to provide a digital IF signal DIF. The AGC circuit 2 provides automatic gain control to amplify the digital IF signal DIF to a digital IF signal X(t), which is in turn supplied to the adaptive digital filter 3. The FM detector 4 detects and demodulates the digital IF signal X(t) based on a digital IF signal Y (t) delivered from the adaptive digital filter 3, thereby producing a demodulated signal Ddet.

As shown in Fig. 1(b), the adaptive digital filter 3 is configured to include: a transfer section 3A having m stages of delay elements DL(1) to DL(m); m+1 multipliers M(0) to M(m) for multiplying the input or output of each of the delay elements DL (1) to DL (m) by tap coefficients h(0) to h(m) ; an adder ADD for summing the outputs from the multipliers M(0) to M(m); a discrimination decision section 3C having an envelope detection section EVD and a subtracter SUB; and an estimation control section 3D. In this configuration, the delay elements DL(1) to DL(m), the multipliers M(0) to M (m), and the adder ADD constitute a transversal filter 3B. Under the control of the estimation control section 3D, the transversal filter 3B adaptively performs predetermined digital filtering on the digital IF signal X(t), and then supplies the output signal from the adder ADD to the FM detector 4 as a digital IF signal Y(t) .

Each of the delay elements DL(1) to DL(m) is set at a predetermined delay time T (expressed by $z^{-1}$ in the z-transform notation) to sequentially transfer an input digital IF signal X(t) to the downstream delay element in accordance with the delay time T.

That is, letting the maximum frequency of the modulated signal SIF be (fmax) and the Nyquist frequency be (2×fmax), the sampling frequency fs of the A/D converter 1 is set to a frequency higher than the Nyquist frequency (2×fmax). Furthermore, the delay time T of each of the delay elements DL(1) to DL(m) is adjusted to the reciprocal of the sampling frequency fs or the sampling cycle (1/fs).

The multipliers M (0) to M (m) allow each of the tap coefficients h(0) to h(m) updated at the estimation control section 3D to be multiplied by the digital IF signals X(t) to X(t-mT) which are the input or output of the delay elements DL(1) to DL(m), respectively. The multiplication results are added up at the adder ADD, thereby producing the digital IF signal Y(t).

The transversal filter 3B configured as described above has a transfer function H(z) expressed by Equation (2a) below and performs predetermined filtering on the input digital IF signal X(t), thereby producing the digital IF signal Y(t) expressed by Equation (2b) below.

[Equation 2]

$$H(z) = \sum_{i=0}^{m} h(i) z^{-1} \qquad \cdots (2a)$$

$$Y(t) = \sum_{i=0}^{m} h(i) X(t - iT)$$

$$= h(0)X(0) + h(1)X(1) + \cdots + h(m/2-1)X(m/2-1) + h(m/2)X(m/2)$$

$$+ h(m/2+1)X(m/2+1) + \cdots + h(m)X(m) \qquad \cdots (2b)$$

The envelope detection section EVD detects the envelope of the digital IF signal Y(t), thereby producing an envelope signal EY(t) indicative of the envelope of the digital IF signal Y(t).

The subtracter SUB computes an error E (t) between the envelope signal EY (t) and a constant reference signal BS. That is, the error E (t) between the reference signal BS indicative of the predetermined constant value and the digital IF signal Y (t) is computed and employed as an evaluation function because the envelope of the ideal FM wave (a modulated signal obtained by Frequency Modulation) is at a constant level.

The estimation control section 3D employs the error E(t) as the evaluation function and follows a predetermined adaptive algorithm to update each of the tap coefficients h(0) to h(m) of the multipliers M (0) to M(m) so that the error E (t) converges (or the error E(t) converges to 0). As such, the frequency characteristics of the transversal filter 3B change to reduce the effects of transmission path characteristics such as multipath characteristics on the intrinsic signal component of the modulated signal SIF contained in the input digital IF signal X(t). This allows for producing the digital IF signal Y(t) with the effects of the transmission path characteristics suppressed.

Furthermore, the receiver of the present embodiment starts receiving, for example, when the user turns ON the power supply of the receiver or when the receiver is initialized following an instruction from the user even during reception. That is, when the receiver starts its originally intended reception operation (hereinafter referred to as "at the initial time"), the estimation control section 3D operates as follows. That is, the estimation control section 3D initializes each of the tap coefficients h(0) to h (m) of the multipliers M (0) to M (m) to a predetermined coefficient value (hereinafter referred to as the "initial coefficient value"). This allows for setting the transversal filter 3B to the frequency characteristics of a high-pass filter which prevent the passage of a direct current component contained in the digital IF signal X(t). Or, the transversal filter 3B is set to the frequency characteristics of a band-pass filter which prevent the passage of a direct current component contained in the digital IF signal X(t) and which encompass the frequency bandwidth of a signal component contained in the digital IF signal X (t) (i.e., the frequency bandwidth of the modulated signal SIF). Then, after the initial setting, the transversal filter 3B starts updating each of the tap coefficients h(0) to h(m) of the multipliers M(0) to M(m) following the predetermined adaptive algorithm so that the error E(t) converges (or the error E(t) converges to 0). Thus, the transversal filter 3B provides adaptive control so as to reduce the effects of transmission path characteristics such as multipath characteristics.

That is, at the initial time, the estimation judgment section 3D sets the transversal filter 3B to the frequency characteristics of the aforementioned high-pass filter or band-pass filter, thereby starting adaptive processing following the predetermined adaptive algorithm with the error E(t) delivered from the subtracter SUB being employed as the first evaluation function. Thus, the estimation judgment section 3D allows each of the tap coefficients h(0) through h (m) of the multipliers M (0) through M (m) to be updated or adjusted so that the error E(t) converges (or the error E(t) converges to 0).

When the estimation judgment section 3D performs the initialization processing in this manner to set the tap coefficients h(0) through h(m) to the predetermined initial coefficient value, a direct current component may be contained in the digital IF signal X(t). In this case, the transversal filter 3B prevents the passage of the direct current component to produce the digital IF signal Y(t). Moreover, the error E(t) between the envelope signal EY(t) of the digital IF signal Y (t) and the reference signal BS is supplied to the estimation control section 3D. Then, after the initialization processing, the estimation judgment section 3D starts the adaptive control so as to reduce the effects of transmission path characteristics such as multipath characteristics. Thus, the estimation judgment section 3D employs the aforementioned error E(t) supplied during the initialization processing as the first evaluation function to adaptively adjust the tap coefficients h(0) to h(m) so that the error E(t) converges (or the error E(t) converges to 0). Accordingly, even when a direct current component is contained in the digital IF signal X(t), adaptive control can be provided to prevent the effects of the direct current component, thereby reducing the effects of transmission path characteristics such as multipath characteristics on the signal component of the IF signal SIF.

As described above, during the predetermined initialization processing, the adaptive digital filter 3 of the present embodiment sets the tap coefficients h(0) through h(m) to a predetermined initial coefficient value, thereby setting the transversal filter 3b to the aforementioned high-pass filter or band-pass filter, and then subsequently starts the adaptive control. Thus, even when a direct current component is contained in the digital IF signal X(t), the adaptive control can be provided to suppress the effects of the direct current component, thereby reducing the effects of transmission path characteristics such as multipath characteristics on the intrinsic signal component of the IF signal SIF of the digital IF signal X(t). The adaptive control can be thus provided to suppress the effects of a direct-current component caused by a direct current offset in the A/D converter 1 and a direct-current component amplified in the AGC circuit, thereby reducing the effects of transmission path characteristics such as multipath characteristics.

Furthermore, according to the receiver of the present embodiment, the FM detector 4 performs detection and demodulation based on the digital IF signal Y(t) supplied from the adaptive digital filter 3, thereby making it possible to improve the S/N or the like of the demodulated signal Ddet.

Furthermore, as described above, even when a direct current component is contained in the digital IF signal X(t), the adaptive digital filter 3 suppresses the effects of the direct current component, thereby facilitating the adjustments made to the direct current offset of the A/D converter 1 provided in the receiver and the gain of the AGC circuit 2. This effectively allows for improving the design flexibility of the receiver and simplifying the adjustments made during the manufacturing processes.

Furthermore, the configuration of the receiver of the present embodiment is suitable for a digital receiver which is intended to produce the demodulated signal Ddet from the modulated signal SIF by digital signal processing.

Note that the adaptive digital filter 3 described above was illustrated to be formed in so-called hardware. However, a computer program which provides the same function may also be prepared. The computer program may be executed on a digital signal processor (DSP) or a microprocessor (MPU), thereby providing adaptive digital filtering so as to reduce the effects of transmission path characteristics such as multipath characteristics.

**[Example]**

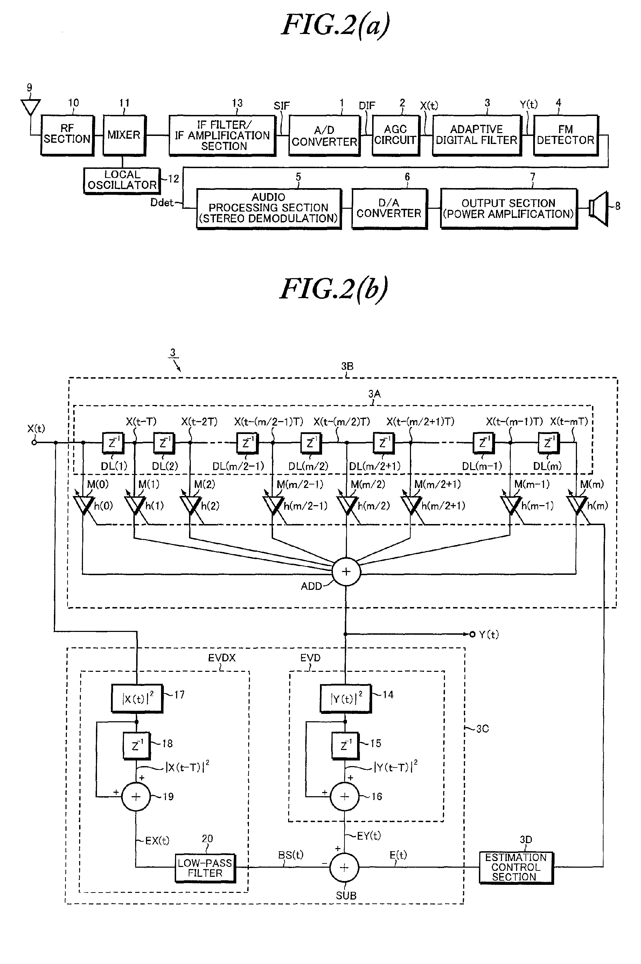

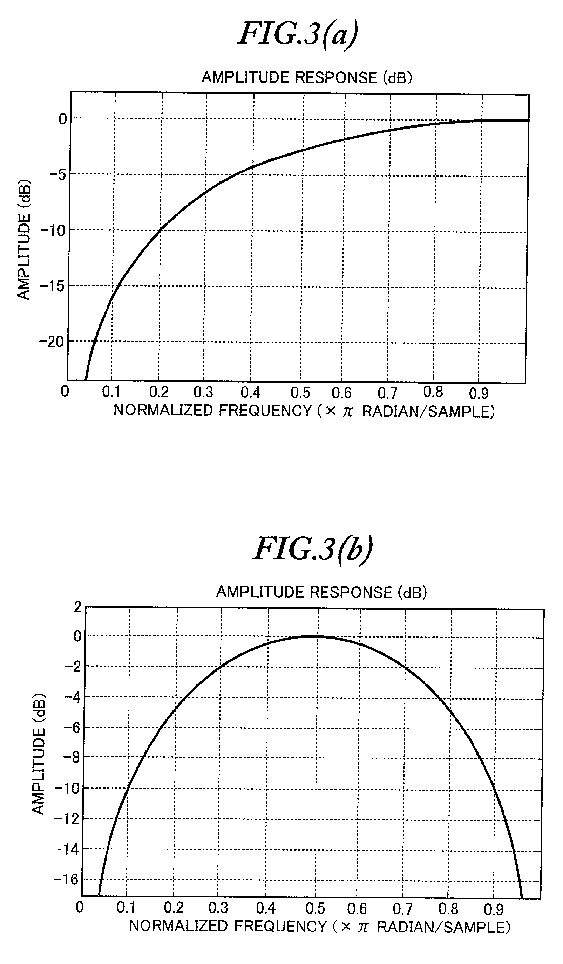

With reference to Figs. 2 and 3, a description will now be made to a more specific example of the adaptive digital filter and the receiver.

Fig. 2 (a) is a block diagram illustrating the configuration of the receiver according to the present example, with the components the same as or equivalent to those of Fig. 1 (a) being indicated with the same symbols. Fig. 2 (b) is a block diagram illustrating the configuration of the adaptive digital filter, with the components the same as or equivalent to those of Fig. 1(a) being indicated with the same symbols. Figs. 3 (a) and (b) each show a characteristic diagram illustrating the frequency characteristics of the adaptive digital filter.

In Fig. 2(a), the receiver of the present example is configured to include: an antenna 9 and a RF section 10 for receiving incoming radio waves such as FM broadcasts; a mixer 11 for mixing a high-frequency received signal delivered from the RF section 10 with a local signal from a local oscillator 12 and then frequency converting the resulting signal into an intermediate frequency signal; an IF filter and IF amplification section 13 for extracting an IF signal (modulated signal) SIF of a predetermined occupied frequency bandwidth from the intermediate frequency signal; the A/D converter 1; the AGC circuit 2; the adaptive digital filter 3; the FM detector 4; and an audio processing section 5, a D/A converter 6, and an output section 7, which stereo demodulate an output (demodulated signal) Ddet from the FM detector 4 for digital to analog conversion and power amplify the resulting signal for delivery to a speaker 8.

Configured in the same manner as in Fig. 1(b), the adaptive digital filter 3 includes: the transfer section 3A having m stages (m is an even number) of delay elements DL (0) to DL(m); the m+1 multipliers M(0) to M(m) whose tap coefficients h(0) to h(m) are adjusted by the discrimination decision section 3C; the adder ADD; the discrimination decision section 3C; and the estimation control section 3D. Furthermore, each delay time T of the multipliers M(0) to M (m) is set according to the sampling cycle of the A/D converter 1.

Here, the transfer section 3A, the multipliers M(0) to M(m), and the adder ADD constitute a transversal filter (i.e., a FIR (Finite Impulse Response) type digital filter) 3B having the transfer function H (z) expressed by Equation (2a). The FIR filter 3B produces the digital IF signal Y(t) expressed by Equation (2b) corresponding to the input digital IF signal X(t).

The discrimination decision section 3C is configured to have two envelope detection sections EVD and EVDX.

The envelope detection section EVD is configured to include: an operational unit 14 for computing the squared absolute value $|Y(t)|^2$ of the digital IF signal Y(t) produced at the adder ADD; a delay element 15 for delaying the output from the operational unit 14 with the same delay time as each delay time T of the multipliers M(0) to M(m); and an adder 16 for adding the squared value $|Y(t)|^2$ computed at the operational unit 14 and the output value $|Y(t-T)|^2$ from the delay element 15, thereby producing the envelope signal EY(t) indicative of the envelope of the digital IF signal Y(t).

The envelope detection section EVDX is configured to include: an operational unit 17 for computing the squared absolute value $|X(t)|^2$ of the digital IF signal X (t) ; a delay element 18 for delaying the output from the operational unit 17 with the same delay time as each delay time T of the multipliers M(0) to M(m); an adder 19 for adding the squared value $|X(t)|^2$ computed at the operational unit 17 and the output value $|X(t-T)|^2$ from the delay element 18, thereby producing an envelope signal EX (t) indicative of the envelope of the digital IF signal X(t); and a digital low-pass filter 20 for smoothing the envelope signal EX(t), thereby producing a direct current reference signal BS (t).

The subtracter SUB computes the error E(t) between the reference signal BS (t) and the envelope signal EY (t), and supplies it to the estimation control section 3D as an evaluation function.

With the error E (t) employed as the evaluation function, the estimation control section 3D follows a predetermined adaptive algorithm to update each of the tap coefficients h(0) to h(m) of the multipliers M(0) to M(m) so that the error E(t) converges (or the error E(t) converges to 0). Accordingly, the frequency characteristics of the transversal filter 3B are changed so as to reduce the effects of transmission path characteristics such as multipath characteristics on the modulated signal SIF intrinsic signal component contained in the input digital IF signal X(t). This allows the digital IF signal Y (t) to be produced with the effects of the transmission path characteristics suppressed.

Furthermore, "at the initial time" at which the receiver of this embodiment starts receiving, the estimation control section 3D initializes each of the tap coefficients h(0) to h(m) of the multipliers M(0) to M(m) to a predetermined "initial coefficient value". This allows for setting the transversal filter 3B to the frequency characteristics of a high-pass filter which prevent the passage of a direct current component contained in the digital IF signal X(t). Or, this allows for setting the transversal filter 3B to the frequency characteristics of a band-pass filter which prevent the passage of a direct current component contained in the digital IF signal X(t) and which encompass the frequency bandwidth of the signal component of the digital IF signal X(t) (i.e., the frequency bandwidth of the modulated signal SIF).

In the present example, each of the tap coefficients h(0) to h (m) is initialized to the predetermined "initial coefficient value" so that the FIR filter 3B has the transfer function H(z) expressed by Equation (3a) below or Equation (3b) below.

$$[\text{Equation } 3]$$

$$H(z) = (1 - z^{-1}) / 2 \qquad \cdots (3a)$$

$$H(z) = (1 - z^{-3}) / 2 \qquad \cdots (3b)$$

More specifically, the tap coefficient h(m/2) of the delay element (i.e., the centrally located delay element) M (m/2) is set to 0.5 which is connected to the output from the (m/2)th-stage delay element DL (m/2) of the m+1 multipliers M(0) to M(m). Additionally, the tap coefficient h (m/2+1) of the subsequent delay element M(m/2+1) is set to -0.5. The tap coefficients h(0) to h(m/2-1) and h(m/2+1) to h (m) of the remaining delay elements M(0) to M(m/2-1) and M(m/2+1) to M(m) are set to 0. This allows for setting the FIR filter 3B to the frequency characteristics of the high-pass filter shown in Fig. 4(a).

Furthermore, as another specific example, the tap coefficient h(m/2) of the centrally located delay element M (m/2) is set to 0, the tap coefficient h(m/2-1) of the delay element M(m/2-1) is set to 0.5, and the tap coefficient h(m/2+1) of the delay element M(m/2+1) is set to -0.5. Additionally, the tap coefficients h(0) to h(m/2-2) and h(m/2+2) to h(m) of the remaining delay elements M(0) to M(m/2-2) and M(m/2+2) to M(m) are set to 0, thereby setting the FIR filter 3B to the frequency characteristics of the band-pass filter shown in Fig. 4(b).

As such, the tap coefficients h(0) to h(m) are initialized to the predetermined "initial coefficient value". This allows for setting the transversal filter 3B to the frequency characteristics of the high-pass filter which prevent the passage of a direct current component contained in the digital IF signal X(t). Or, the transversal filter 3B is set to the frequency characteristics of the band-pass filter which prevent the passage of a direct current component contained in the digital IF signal X(t) and which encompass the frequency bandwidth of the modulated signal SIF.

Furthermore, the estimation control section 3D sets the transversal filter 3B to the frequency characteristics of the aforementioned high-pass filter or band-pass filter, thereby initiating adaptive processing in accordance with the predetermined adaptive algorithm using the error E(t) delivered from the subtracter SUB as the first evaluation function. Then, the estimation control section 3D updates or adjusts each of the tap coefficients h(0) to h(m) of the multipliers M (0) to M(m) so that the error E(t) converges (or the error E(t) converges to 0). The adaptive control is thus provided to reduce the effects of transmission path characteristics such as multipath characteristics.

According to the adaptive digital filter 3 of the present example described above, the envelope detection section EVDX envelope-detects and smoothes the digital IF signal X(t), thereby producing a direct current reference signal BS (t). With the error E(t) between the reference signal BS(t) and the envelope signal EY(t) of the digital IF signal Y(t) being employed as the evaluation function, the estimation control section 3D adaptively adjusts the tap coefficients h(0) to h (m) so that the error E(t) converges (or the error E(t) converges to 0). This allows for adjusting the amplitude of the digital IF signal Y(t) to the amplitude of the digital IF signal X(t) . It is thus possible to produce the digital IF signal Y(t) without compromising the amount of information of the digital IF signal X(t).

Furthermore, according to the adaptive digital filter 3 of the present embodiment, at the time of the predetermined initialization processing, the transversal filter 3B is set to the aforementioned high-pass filter or band-pass filter by setting the tap coefficients h(0) to h(m) to the predetermined initial coefficient value, and then initiates the adaptive control. Thus, even when a direct current component is contained in the digital IF signal X(t), the adaptive control can be provided so as to suppress the effects of the direct current component. This allows for reducing the effects of transmission path characteristics such as multipath characteristics on the intrinsic signal component of the IF signal SIF of the digital IF signal X(t). It is thus possible to suppress the effects of a direct-current component such as the direct current offset caused at the A/D converter 1 or a direct-current component amplified at the AGC circuit. As such, the adaptive control can be provided so as to reduce the effects of transmission path characteristics such as multipath characteristics.

Even upon reception of weak electric fields, full use can be made of the adaptive digital filter 3, thereby producing a digital IF signal Y(t) for eliminating multipath distortions to produce a demodulated signal with a high S/N ratio.

According to the receiver of the present embodiment, the FM detector 4 can also perform detection and demodulation based on the digital IF signal Y(t) supplied from the adaptive digital filter 3, thereby providing an improved S/N ratio to the demodulated signal Ddet.

Furthermore, even when a direct current component is contained in the digital IF signal X(t) as described above, the adaptive digital filter 3 suppresses the effects of the direct current component. This facilitates adjusting of the direct current offset of the A/D converter 1 provided in the receiver and the gain of the AGC circuit 2. This effectively allows for improving the design flexibility of the receiver and simplifying the adjustments made during the manufacturing processes.

Note that the present example described above is configured such that the adaptive digital filter 3 functions to prevent the passage of the direct current component of the digital IF signal X(t). However, it is also acceptable to provide a digital high-pass filter or a digital bandpass filter between the A/D converter 1 and the AGC circuit 2 to prevent the passage of direct current components contained in the digital IF signal DIF.

Furthermore, between the AGC circuit 2 and the adaptive digital filter 3, a digital high-pass filter or a digital bandpass filter may also be provided to prevent the passage of direct current components contained in the digital IF signal X(t).

Thus, the adaptive digital filter 3 may be configured to have the function for preventing the passage of the direct current component of the digital IF signal X(t). In addition to this configuration, a digital high-pass filter or a digital bandpass filter may also be provided between the A/D converter 1 and the AGC circuit 2 to prevent the passage of direct current components contained in the digital IF signal DIF. It is also possible to provide a digital high-pass filter or a digital bandpass filter between the AGC circuit 2 and the adaptive digital filter 3 to prevent the passage of direct current components contained in the digital IF signal X(t). As such, provision of the adaptive digital filter 3 which prevents the passage of direct current components of the digital IF signal X(t), and a digital high-pass filter or digital bandpass filter makes it possible to more positively suppress the effects of direct current components.

Furthermore, the adaptive digital filter 3 of this implementation example described above was illustrated to be formed in so-called hardware. However, a computer program which provides the same function may also be prepared. The computer program may be executed on a digital signal processor (DSP) or a microprocessor (MPU), thereby providing adaptive digital filtering so as to reduce the effects of transmission path characteristics such as multipath characteristics.

**Claims**

1. An adaptive digital filter for eliminating effects of transmission path characteristics such as multipath characteristics from a digitized modulated signal, the adaptive digital filter comprising:

   a transversal filter for performing predetermined digital filtering on said digitized modulated signal;
   discrimination decision means for computing an error between an envelope of an output from said transversal filter and a predetermined reference value; and
   estimation control means for providing adaptive control by adjusting a tap coefficient of said transversal filter for said error to converge, so that said output from the transversal filter is produced as a modulated signal with said effects of transmission path characteristics such as multipath characteristics eliminated, wherein
   said estimation control means provides said adaptive control after said tap coefficient is set to a predetermined initial coefficient value, thereby setting frequency characteristics of said transversal filter to such frequency characteristics that prevent passage of a direct current component contained in said digitized modulated signal.

2. The adaptive digital filter according to claim 1, wherein said initial coefficient value of said tap coefficient is a coefficient value for setting said frequency characteristics of the transversal filter to frequency characteristics of a high-pass filter.

3. The adaptive digital filter according to claim 1, wherein said initial coefficient value of said tap coefficient is a coefficient value for setting said frequency characteristics of the transversal filter to frequency characteristics of a band-pass filter including a frequency bandwidth of said digitized modulated signal.

4. A receiver comprising:

   the adaptive digital filter according to any one of claims 1 to 3;
   an A/D converter for analog-to-digital conversion of an analog modulated signal;
   automatic gain control means for providing automatic gain control to an output from said A/D converter to produce said digitized modulated signal for supply to said adaptive digital filter; and

detector means for detecting and demodulating an output from said transversal filter.

5. A method for performing adaptive digital filtering to eliminate effects of transmission path characteristics such as multipath characteristics from a digitized modulated signal, the method comprising:

a digital filtering step of performing predetermined digital filtering on said digitized modulated signal;
a discrimination decision step of computing an error between an envelope of said digitally filtered signal from said digital filtering step and a predetermined reference value; and
an estimation control step of providing adaptive control by adjusting a tap coefficient in said digital filtering step for said error to converge, so that said digitally filtered signal is produced as a modulated signal with said effects of transmission path characteristics such as multipath characteristics eliminated,

wherein,
in said estimation control step, said adaptive control is provided after said tap coefficient is set to a predetermined initial coefficient value, thereby setting frequency characteristics for said digital filtering in said digital filtering step to such frequency characteristics that prevent passage of a direct current component contained in said digitized modulated signal.

6. A computer program for allowing a computer to perform adaptive digital filtering to eliminate effects of transmission path characteristics such as multipath characteristics from a digitized modulated signal, the computer program comprising:

a digital filtering step of performing predetermined digital filtering on said digitized modulated signal;
a discrimination decision step of computing an error between an envelope of said digitally filtered signal from said digital filtering step and a predetermined reference value; and
an estimation control step of providing adaptive control by adjusting a tap coefficient of said digital filtering step for said error to converge, so that said digitally filtered signal is produced as a modulated signal with said effects of transmission path characteristics such as multipath characteristics eliminated,

wherein,
in the estimation control step, said adaptive control is provided after said tap coefficient is set to a predetermined initial coefficient value, thereby setting frequency characteristics for said digital filtering in said digital filtering step to such frequency characteristics that prevent passage of a direct current component contained in said digitized modulated signal.

FIG.1(a)

SIF — [1] A/D CONVERTER — DIF — [2] AGC CIRCUIT — X(t) — [3] EQUALIZER (ADAPTIVE DIGNITAL FILTER) — Y(t) — [4] FM DETECTOR — Ddet

FIG.1(b)

EP 1 983 657 A1

## FIG.2(a)

## FIG.2(b)

## FIG.3(a)

AMPLITUDE RESPONSE (dB)

## FIG.3(b)

AMPLITUDE RESPONSE (dB)

<table>
<tr><td colspan="2" align="center"><b>INTERNATIONAL SEARCH REPORT</b></td><td>International application No.<br><br>PCT/JP2006/323587</td></tr>
</table>

A. CLASSIFICATION OF SUBJECT MATTER
*H04B7/005*(2006.01)i, *H03H21/00*(2006.01)i, *H04B1/10*(2006.01)i, *H04B3/06*
(2006.01)i, *H04L27/01*(2006.01)i

According to International Patent Classification (IPC) or to both national classification and IPC

B. FIELDS SEARCHED

Minimum documentation searched (classification system followed by classification symbols)
H04B7/005, H03H21/00, H04B1/10-1/14, H04B3/04-3/18, H04L27/01

Documentation searched other than minimum documentation to the extent that such documents are included in the fields searched
Jitsuyo Shinan Koho          1922-1996    Jitsuyo Shinan Toroku Koho    1996-2007
Kokai Jitsuyo Shinan Koho    1971-2007    Toroku Jitsuyo Shinan Koho    1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2005-167717 A  (Pioneer Electronic Corp.),<br>23 June, 2005 (23.06.05),<br>Full text; all drawings<br>& US 2005/0123035 A1    & EP 1542415 A2 | 1-6 |
| A | JP 2005-64618 A  (Pioneer Electronic Corp.),<br>10 March, 2005 (10.03.05),<br>Full text; all drawings<br>& US 2005/0053177 A1    & EP 1508968 A2 | 1-6 |

☐ Further documents are listed in the continuation of Box C.          ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>20 February, 2007 (20.02.07) | Date of mailing of the international search report<br>27 February, 2007 (27.02.07) |
|---|---|
| Name and mailing address of the ISA/<br>Japanese Patent Office | Authorized officer |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI10209890 B